# EUROPÄISCHE PATENTANMELDUNG

(11) **EP 4 810 966 A1**
(43) Veröffentlichungstag der Anmeldung: **23.09.2026**
(21) Anmeldenummer: 26163682.3
(22) Anmeldetag: 10.03.2026
(51) Int. Cl.: G01R 31/12, G01R 31/58, H02H 1/00, B60L 53/16, B62D 5/04, G01R 31/00, G01R 31/68, G01R 31/364

(54) **VERFAHREN ZUR LICHTBOGENERKENNUNG AN EINER STECKVERBINDUNG EINES LENKSYSTEMS EINES KRAFT-FAHRZEUGS, STECKVERBINDUNG, SOWIE KRAFTFAHRZEUG**

(30) Priorität: 21.03.2025 DE 102025111080
(71) Anmelder: Volkswagen Aktiengesellschaft, 38440 Wolfsburg (DE)
(72) Erfinder: Kreis, Christopher, 38440 Wolfsburg (DE); Wilske, Stefan, 38440 Wolfsburg (DE); Hein, Pia Marie, 38440 Wolfsburg (DE)

(57) **Zusammenfassung**

Die Erfindung betrifft ein Verfahren zur Lichtbogenerkennung an einer elektrischen Steckverbindung (26) eines Lenksystems (20) eines Kraftfahrzeugs (10), umfassend die Schritte: Erfassen eines zeitlichen Signalverlaufs eines Ist-Wertes einer Spannung und/oder Stromstärke zumindest an einer elektrischen Steckverbindung (26) des Lenksystems (20); Erkennen eines Lichtbogens (40) anhand eines für den Lichtbogen (40) charakteristischen Signals, welches zumindest ein durch die strukturelle Ausgestaltung der elektrischen Steckverbindung (26) bedingtes charakteristisches Muster aufweist, wobei die strukturelle Ausgestaltung eine spezifische Form, Anordnung oder definierte Anzahl von Kontaktelementen umfasst; Durchführen zumindest einer Maßnahme, wenn ein Lichtbogen (40) erkannt wurde, wobei die Maßnahme ein Absenken oder Abschalten einer Spannung im Bordnetz umfasst. Des Weiteren betrifft die Erfindung eine Steckverbindung (26), eine Steuereinrichtung (30) zur Durchführung eines solchen Verfahrens sowie ein Kraftfahrzeug (10) mit einer Steckverbindung (26) und einer Steuereinrichtung (30).

## Beschreibung

Die vorliegende Erfindung betrifft ein Verfahren zur Lichtbogenerkennung an einer Steckverbindung eines Lenksystems eines Kraftfahrzeugs, eine Steckverbindung, eine Steuereinrichtung zur Durchführung eines solchen Verfahrens sowie ein Kraftfahrzeug mit einer solchen Steckverbindung und einer solchen Steuereinrichtung.

DE 10 2014 217 851 A1 betrifft eine Lichtbogendetektionseinrichtung für die Gleichstromladung eines Akkumulators von Elektrofahrzeugen. Die Erfindung zielt darauf ab, einen Lichtbogen, der durch unbeabsichtigtes Ziehen des Ladesteckers während des Ladevorgangs entstehen kann, frühzeitig zu erkennen und zu unterbrechen. Hierzu umfasst die Einrichtung eine Steckvorrichtung mit elektrischen Kontakten, eine Vorrichtung zum Messen einer physikalischen Größe nahe der elektrischen Kontakte, eine Trennvorrichtung und eine Steuerungsvorrichtung. Die physikalische Größe kann elektromagnetische Strahlung, Umgebungsdruck oder ein elektrischer Widerstandswert sein, wobei besonders bevorzugt ein temperaturabhängiger Widerstand direkt am elektrischen Kontakt angebracht wird. Die Steuerung trennt die Stromversorgung, sobald die Änderung der gemessenen physikalischen Größe einen vorbestimmten Schwellwert überschreitet.

DE 10 2014 012 014 A1 betrifft eine Schaltungsanordnung zur Erkennung eines Lichtbogens in einem Kraftfahrzeug. Die Schaltungsanordnung umfasst ein Bordnetz mit Batterie und Verbraucher, ein Steuergerät zum Schalten der Batterie sowie einen Detektor für ultraviolette Strahlung. Das zentrale Element ist eine Auswerteeinheit, die eine dynamische Auswertung des Licht-Messsignals durchführt und in Abhängigkeit einer Änderungsrate des Signals ein Vorhandensein eines Lichtbogens erkennt. Durch die Verwendung der Änderungsrate können Umgebungslichtschwankungen von tatsächlichen Lichtbogenereignissen unterschieden werden, wodurch Fehlalarme vermieden werden.

DE 10 2015 209 588 B3 betrifft eine Vorrichtung und ein Verfahren zum Erkennen von Störungen in einem Bordnetz. Die Erfindung ermöglicht eine Erkennung von Lichtbögen aus asynchronen und zeitverzögerten Messwerten. Die Vorrichtung umfasst eine Empfangseinrichtung für zwei zeitliche Folgen von Messwerten (Strom- oder Spannungswerte) von verschiedenen Messpunkten des Bordnetzes sowie eine Auswerteeinrichtung. Die Auswerteeinrichtung erkennt Störungen durch Vergleich der Streuung der Messwerte an beiden Messpunkten. Ändert sich die Streuung an einem Messpunkt signifikant gegenüber dem anderen, wird eine Störung erkannt.

Es ist die Aufgabe der Erfindung, eine schnelle und präzise Erkennung eines Lichtbogens und die Abschaltung eines solchen Lichtbogens in einem Lenksystem eines Kraftfahrzeugs zu ermöglichen.

Diese Aufgabe wird durch die Gegenstände der unabhängigen Ansprüche gelöst. Weitere mögliche Ausgestaltungen der Erfindung sind in den Unteransprüchen, der Beschreibung und den Figuren offenbart. Merkmale, Vorteile und mögliche Ausgestaltungen, die im Rahmen der Beschreibung für einen der Gegenstände der unabhängigen Ansprüche dargelegt sind, sind zumindest analog als Merkmale, Vorteile und mögliche Ausgestaltungen des jeweiligen Gegenstands der anderen unabhängigen Ansprüche sowie jeder möglichen Kombination der Gegenstände der unabhängigen Ansprüche, gegebenenfalls in Verbindung mit einem oder mehr der Unteransprüche, anzusehen.

Erfindungsgemäß wird ein Verfahren zur Lichtbogenerkennung an einer elektrischen Steckverbindung eines Lenksystems eines Kraftfahrzeugs bereitgestellt. In einem ersten Schritt erfolgt das Erfassen eines zeitlichen Signalverlaufs eines Ist-Wertes einer Spannung und/oder Stromstärke zumindest an einer elektrischen Steckverbindung des Lenksystems. In einem weiteren Schritt erfolgt das Erkennen eines Lichtbogens anhand eines für den Lichtbogen charakteristischen Signals, welches zumindest ein durch die strukturelle Ausgestaltung der elektrischen Steckverbindung bedingtes charakteristisches Muster aufweist, wobei die strukturelle Ausgestaltung eine spezifische Form, Anordnung oder definierte Anzahl von Kontaktelementen umfasst. In einem weiteren Schritt erfolgt das Durchführen zumindest einer Maßnahme, wenn ein Lichtbogen erkannt wurde, wobei die Maßnahme ein Absenken oder Abschalten einer Spannung im Bordnetz umfasst.

Die Erfindung hat den Vorteil, dass ein Lichtbogen an einer Steckverbindung schneller erkannt und präziser lokalisiert werden kann, d. h. die betroffene Komponente kann mit verbesserter Genauigkeit erkannt werden. Dies ermöglicht eine schnelle und spezifische Abschaltung des Lichtbogens, wodurch Schäden an den elektrischen bzw. elektronischen Komponenten des Lenksystems vermieden werden können.

Ein Kraftfahrzeug im Rahmen der Erfindung kann als ein angetriebenes Fahrzeug verstanden werden. Ein Kraftfahrzeug im Rahmen der Erfindung kann insbesondere ein Personenkraftwagen sein, welcher ein 48 V-Bordnetz aufweist.

Ein Lenksystem im Rahmen der Erfindung kann verstanden werden als ein elektromechanisches System zur Umsetzung von Lenkbewegungen in einem Kraftfahrzeug, das elektrische und mechanische Komponenten zur Steuerung der Fahrzeugrichtung umfasst. Ein Lenksystem im Rahmen der Erfindung umfasst einen Lenkungsmotor, ein Lenkungsmotorsteuergerät, einen Wechselrichter und zumindest eine Steckverbindung. Ein Lenkungsmotor im Rahmen der Erfindung kann insbesondere ein dreiphasiger Wechselstrommotor sein. Ein Lenkungssystem im Rahmen der Erfindung kann auch eine Sensorik umfassen, beispielsweise einen Lenkwinkelsensor, einen Drehmoment-Sensor, einen Motor-Positions-Sensor wie z. B. einen Resolver oder magnetoresistiven Sensor, sowie Strom- und Spannungssensoren zur Überwachung des elektrischen Betriebszustands. Weiterhin kann das Lenksystem Sicherheitskomponenten umfassen, wie z. B. einen Phasentrenner im elektrischen Versorgungspfad, einen oder mehrere mechanische Schaltkontakte an einer oder mehreren Steckverbindungen, sowie einen oder mehrere Sensoren zur Detektion von elektrischen und magnetischen Feldern, z. B. einen Hall-Sensor oder eine Induktionsspule. Das Lenksystem kann zudem eine Kommunikationsschnittstelle zur Verbindung mit anderen Steuergeräten des Kraftfahrzeugs, insbesondere über ein Bordnetz, aufweisen sowie weitere Mittel zur Erkennung einer Lichtbogenbildung an elektrischen Steckverbindungen.

Eine elektrische Steckverbindung im Rahmen der Erfindung kann verstanden werden als eine Vorrichtung zur Herstellung einer elektrischen Verbindung, welche einen Stecker und eine Buchse umfasst und die durch das Zusammenfügen des Steckers und der Buchse hergestellt wird. Derartige Steckverbindungen dienen typischerweise einer reversiblen elektrischen Kontaktierung zwischen Leitungen oder zwischen einer Leitung und einem elektrischen Gerät. Sie zeichnen sich typischerweise durch eine mechanische Führungsstruktur zur korrekten Ausrichtung der Kontakte sowie durch Kontaktelemente zur elektrischen Übertragung aus. Eine Steckverbindung im Rahmen der Erfindung kann insbesondere eine Steckverbindung innerhalb eines Lenksystems eines Kraftfahrzeugs sein, beispielsweise zur Übertragung elektrischer Signale oder zur Energieversorgung von Steuergeräten, Sensoren oder Aktuatoren wie z. B. einem Lenkungsmotor.

Eine strukturelle Ausgestaltung der Steckverbindung im Rahmen der Erfindung kann verstanden werden als die konstruktive und geometrische Gestaltung der mechanischen und elektrischen Komponenten einer Steckverbindung. Dazu zählen insbesondere die Form und Anordnung der Kontaktelemente, die Anzahl der Kontakte sowie das verwendete Material. Die strukturelle Ausgestaltung beeinflusst die elektrischen Eigenschaften der Steckverbindung und kann insbesondere für die Entstehung oder Vermeidung von Lichtbögen relevant sein. Die strukturelle Ausgestaltung kann so gewählt sein, dass bei einem Trennvorgang ein Lichtbogen bevorzugt an einer bestimmten, dafür vorgesehenen Position entsteht, wodurch andere empfindliche Komponenten der Steckverbindung vor Beschädigung geschützt werden. Ferner kann die strukturelle Ausgestaltung spezielle Schutzmechanismen umfassen, wie etwa eine Beschichtung oder andere Mittel, welche die Steckverbindung vor Beschädigung durch Lichtbogenbildung schützen. Ein strukturelle Ausgestaltung der Steckverbindung kann beispielsweise eine Konturierung der Kontaktelemente umfassen. Andere strukturelle Ausgestaltungen können beispielsweise gestaffelte Kontaktlängen umfassen, bei denen bestimmte Kontakte (wie Masse- oder Signalkontakte) früher oder später trennen als Leistungskontakte, was einen kontrollierten Trennvorgang ermöglicht. Andere strukturelle Ausgestaltungen können Federelemente zur Optimierung des Kontaktdrucks, Versiegelungselemente zum Schutz vor Umwelteinflüssen und Verunreinigungen, oder spezielle Geometrien zur Wärmeableitung umfassen. Die Steckverbindung kann auch mit einer definierten Trennrichtung ausgestattet sein, die sicherstellt, dass der Trennvorgang stets in einer vorbestimmten Weise erfolgt, was die Vorhersagbarkeit und Kontrollierbarkeit des Lichtbogenverhaltens verbessert. Die Kontaktelemente können zudem mit speziellen Legierungen oder Oberflächenbehandlungen versehen sein, die den elektrischen Widerstand minimieren und gleichzeitig die Lichtbogenbeständigkeit erhöhen, wie etwa silber- oder goldplattierte Kontakte mit zusätzlicher Hartmetallbeschichtung an definierten Stellen.

Ein Lichtbogen im Rahmen der Erfindung kann verstanden werden als eine elektrische Entladung zwischen zwei leitenden Elementen, die durch eine hohe Stromdichte und eine lokal stark erhöhte Temperatur gekennzeichnet ist. Derartige Lichtbögen entstehen insbesondere dann, wenn eine elektrische Verbindung unter Last unterbrochen wird oder wenn aufgrund eines erhöhten Übergangswiderstands an einer Steckverbindung eine ungewollte Entladung erfolgt. Lichtbögen sind mit typischen physikalischen Effekten wie intensiver Wärmestrahlung, Plasma-Bildung und einer charakteristischen Emission elektromagnetischer Wellen verbunden. Ein Lichtbogen im Rahmen der Erfindung kann insbesondere an einer Steckverbindung eines Lenksystems auftreten, beispielsweise infolge von Verschleiß, unzureichendem Kontakt oder Vibrationen. Dabei kann typischerweise zwischen einem seriellen und einem parallelen Lichtbogen unterschieden werden: Ein serieller Lichtbogen entsteht innerhalb eines stromführenden Leiters oder einer Steckverbindung, wenn der elektrische Kontakt unterbrochen oder verschlechtert wird. Dieser Lichtbogentyp tritt häufig bei beschädigten oder gelockerten Verbindungen auf und kann zu unkontrollierten Spannungs- und Stromspitzen führen. Ein paralleler Lichtbogen entsteht zwischen zwei benachbarten, potenzialunterschiedlichen Leitern, beispielsweise durch eine Isolationsschädigung oder eine Verschmutzung. Diese Art von Lichtbogen kann durch eine ungewollte Verbindung zwischen zwei elektrischen Potentialen hohe Kurzschlussströme verursachen und zu einem thermischen Schaden führen.

Eine Lichtbogenerkennung im Rahmen der Erfindung kann verstanden werden als ein Verfahren zur Detektion eines elektrischen Lichtbogens anhand charakteristischer Signale bzw. Signalmuster. Derartige Signale bzw. Signalmuster können beispielsweise abrupte Spannungsänderungen, hochfrequente Störsignale oder spezifische Stromflusscharakteristiken umfassen. Eine Lichtbogenerkennung im Rahmen der Erfindung umfasst eine Auswertung eines erfassten zeitlichen Verlaufs von Spannungs- oder Stromwerten an einer Steckverbindung eines Lenksystems.

Eine Maßnahme im Rahmen der Erfindung kann verstanden werden als eine gezielte Reaktion auf die Detektion eines Lichtbogens, um diesen zum Erliegen zu bringen oder dessen Auswirkungen zu minimieren oder die Entstehung eines weiteren Lichtbogens zu verhindern. Derartige Maßnahmen umfassen ein Absenken oder Abschalten der an der Steckverbindung anliegenden Spannung. Insbesondere kann die Maßnahme im Rahmen der Erfindung dazu dienen, Schäden an der Steckverbindung und/oder der Elektronik des Lenksystems zu vermeiden und dessen Funktionsfähigkeit sicherzustellen.

In weiterer Ausgestaltung der Erfindung kann es vorgesehen sein, dass zusätzlich an zumindest zwei Messpunkten im Bordnetz aus dem zeitlichen Verlauf des Ist-Wertes jeweils eine elektrische Leistungsbilanz berechnet wird, wobei eine zeitliche Änderung der Leistungsbilanz an verschiedenen Messpunkten im Bordnetz erfasst wird und anhand eines Vergleichs der jeweiligen Leistungsbilanzen an den zumindest zwei Messpunkten eine Lokalisierung des Lichtbogens im Bordnetz erfolgt. Dies hat den Vorteil, dass durch die differenzielle Leistungsbilanzanalyse an mehreren Messpunkten nicht nur die bloße Existenz eines Lichtbogens erkannt, sondern auch dessen genaue Position im Bordnetz lokalisiert werden kann, was eine gezielte und schnelle Durchführung einer Maßnahme ermöglicht, die den Lichtbogen zum Erliegen bringt.

In einer Ausgestaltung der Erfindung kann es vorgesehen sein, dass das Erkennen des Lichtbogens ferner anhand einer Messung von Licht erfolgt, welches vom Lichtbogen emittiert wird. Dies hat den Vorteil, dass durch die zusätzliche optische Detektion eine eine Ergänzung zur elektrischen Messung bereitgestellt wird, wodurch die Zuverlässigkeit der Lichtbogenerkennung signifikant erhöht und Fehlalarme minimiert werden können. Ein weiterer Vorteil ist, dass bestimmte charakteristische Eigenschaften des Lichtbogens, wie etwa dessen spezifische Lichtemission, direkt detektiert werden können, was eine besonders präzise und frühzeitige Erkennung auch schwacher oder beginnender Lichtbogenbildung ermöglicht, bevor diese im elektrischen Signalverlauf deutlich messbar wird. Zur Erkennung des Lichtbogens anhand des emittierten Lichts kann das Lenksystem verschiedene optische Sensoren aufweisen, z. B. Fotodioden, die strategisch in der Nähe potenzieller Lichtbogenentstehungspunkte platziert sind. Derartige Fotodioden können auf bestimmte Wellenlängenbereiche abgestimmt sein, die für Lichtbögen charakteristisch sind, insbesondere im ultravioletten und infraroten Spektrum, um Störungen durch Umgebungslicht zu minimieren. Alternativ oder zusätzlich dazu kann das Kraftfahrzeug eine Innenraumkamera aufweisen, über welche das Licht detektiert werden kann. Die Kameradaten können mittels Bildverarbeitungsalgorithmen in Echtzeit analysiert werden, um plötzliche Lichtblitze oder charakteristische Lichtmuster zu erkennen, die auf einen Lichtbogen hindeuten.

In einer Ausgestaltung der Erfindung kann es vorgesehen sein, dass das Erkennen des Lichtbogens ferner anhand einer Messung elektrischer und/oder magnetischer Felder erfolgt, welche von dem Lichtbogen erzeugt werden. Dies hat den Vorteil, dass die charakteristischen elektromagnetischen Emissionen des Lichtbogens kontaktlos und ohne direkte elektrische Verbindung detektiert werden können, was eine sichere Überwachung auch in schwer zugänglichen Bereichen des Lenksystems ermöglicht. Ein weiterer Vorteil ist, dass die elektromagnetische Feldmessung spezifische Frequenzmuster des Lichtbogens erfassen kann, die in konventionellen Strom- und Spannungsmessungen möglicherweise überlagert oder gedämpft werden, wodurch eine höhere Detektionsempfindlichkeit und Störunempfindlichkeit erreicht wird. Hierzu kann das Lenksystem einen oder mehrere geeignete Sensoren wie beispielsweise einen Halbleiter-Elektronendetektor, einen Hall-Sensor, eine Induktionsspule, einen Feldstärkesensor zur Messung einer elektrischen oder magnetischen Feldstärke, oder ähnliche elektromagnetische Messeinrichtungen aufweisen, die gezielt auf die Detektion der vom Lichtbogen emittierten elektrischen und magnetischen Felder abgestimmt sind.

In einer Ausgestaltung der Erfindung kann es vorgesehen sein, dass das Erkennen des Lichtbogens ferner anhand eines für den Lichtbogen charakteristischen Signals erfolgt, welches mittels einer Sensorik des Lenksystems erfasst wird. Eine derartige Sensorik des Lenksystems kann beispielsweise Lagesensoren, Motor-Positions-Sensoren wie Resolver oder magnetoresistive Sensoren umfassen. Das Lenksystem kann eine derartige Sensorik aufweisen und die Steuereinrichtung kann auf eine derartige Sensorik zugreifen. Dies hat den Vorteil, dass bereits vorhandene Sensoren des Lenksystems für die Lichtbogenerkennung genutzt werden können, wodurch zusätzliche Sensorik eingespart und die Kosteneffizienz des Gesamtsystems erhöht wird. Ein weiterer Vorteil ist, dass die Lichtbogenerkennung unmittelbar in die bestehende Sensorarchitektur des Lenksystems integriert werden kann, was eine systemnahe Überwachung ermöglicht und durch die direkte Einbindung in die Lenksystemregelung besonders schnelle Reaktionszeiten bei der Fehlerbehandlung gewährleistet.

In einer Ausgestaltung der Erfindung kann es vorgesehen sein, dass die elektrische Steckverbindung einen mechanischen Schaltkontakt zur Unterbrechung der Spannung umfasst, und wobei die Maßnahme das Versetzen der elektrische Steckverbindung in einen spannungsfreien Zustand umfasst, indem der mechanische Schaltkontakt beim physischen Trennen der elektrischen Steckverbindung aktiviert wird. Dies hat den Vorteil, dass durch den integrierten mechanischen Schaltkontakt die Spannungsunterbrechung intrinsisch mit dem physischen Trennvorgang der Steckverbindung gekoppelt ist, wodurch eine zuverlässige Lichtbogenvermeidung ohne zusätzliche Steuerungselektronik oder aktive Eingriffe gewährleistet wird. Ein weiterer Vorteil ist, dass der Sicherheitsmechanismus vollständig passiv und ausfallsicher arbeitet, da er allein durch den mechanischen Trennvorgang aktiviert wird, was eine besonders robuste Absicherung gegen Lichtbogenbildung auch bei Ausfall anderer elektronischer Überwachungs- und Steuerungssysteme bietet und somit die Gesamtzuverlässigkeit des Lenksystems erhöht.

In einer Ausgestaltung der Erfindung kann es vorgesehen sein, dass die Maßnahme das Versetzen des Lenkungsmotorsteuergeräts in einen spannungsfreien Zustand umfasst, indem ein im elektrischen Versorgungspfad des Lenkungsmotorsteuergeräts angeordneter Phasentrenner ausgelöst wird. Dies hat den Vorteil, dass durch den gezielten Einsatz des Phasentrenners im elektrischen Versorgungspfad ein rasches und vollständiges Abschalten der Spannungsversorgung des Lenkungsmotorsteuergeräts erreicht wird, wodurch die Energiequelle für eine weitere Lichtbogenentwicklung unmittelbar eliminiert und Folgeschäden am Lenksystem effektiv verhindert werden. Ein weiterer Vorteil ist, dass durch die dedizierte Platzierung des Phasentrenners im Versorgungspfad des Lenkungsmotorsteuergeräts ein selektives Abschalten möglich ist, das andere sicherheitskritische Systeme des Fahrzeugs unbeeinträchtigt lässt und so ein ausgewogenes Verhältnis zwischen Schutzwirkung und Aufrechterhaltung notwendiger Fahrzeugfunktionen gewährleistet.

In einer Ausgestaltung der Erfindung kann es vorgesehen sein, dass die Maßnahmen das Versetzen des Lenkungsmotors in einen spannungsfreien Zustand umfasst, indem die Schaltelemente eines mit dem Lenkungsmotor verbundenen Wechselrichters so angesteuert werden, dass an der elektrischen Steckverbindung, an welcher der Lichtbogen erkannt wurde, keine Spannung mehr anliegt. Dies hat den Vorteil, dass durch die gezielte Ansteuerung der Wechselrichter-Schaltelemente ein Nullspannungszustand präzise an der betroffenen Steckverbindung erzeugt werden kann, ohne den gesamten Lenkungsmotor vollständig abschalten zu müssen, wodurch eine graduelle und kontrollierte Reaktion auf den erkannten Lichtbogen ermöglicht wird. Ein weiterer Vorteil ist, dass die bestehende Leistungselektronik des Lenkungssystems für die Sicherheitsmaßnahme genutzt werden kann, was ohne zusätzliche Hardware eine schnelle Reaktionszeit gewährleistet und durch die sofortige Spannungsreduzierung an der kritischen Stelle eine effektive Unterbrechung des Lichtbogens bewirkt, während gleichzeitig die grundlegende Funktionalität des Lenksystems aufrechterhalten werden kann. Die Umsetzung dieses Nullspannungszustands kann insbesondere bei einer als H-Brücke oder B6-Brücke ausgeführten Wechselrichterschaltung erfolgen. In einer B6-Brücke mit sechs Schaltelementen (Q1 bis Q6), welche typischerweise als MOSFETs, IGBTs oder Relais ausgeführt sein können, werden dabei alle oberen Schaltelemente (High-Side-Transistoren Q1, Q3, Q5) gleichzeitig in denselben Schaltzustand versetzt - entweder alle eingeschaltet oder alle ausgeschaltet. Gleichzeitig werden alle unteren Schaltelemente (Low-Side-Transistoren Q2, Q4, Q6) in den jeweils entgegengesetzten Zustand versetzt - also ausgeschaltet, wenn die High-Side-Transistoren eingeschaltet sind, und eingeschaltet, wenn die High-Side-Transistoren ausgeschaltet sind. Durch diese symmetrische Ansteuerung wird sichergestellt, dass an allen Phasenausgängen des Wechselrichters das gleiche elektrische Potential anliegt, wodurch die Spannungsdifferenz zwischen beliebigen Anschlüssen auf Null reduziert wird.

Erfindungsgemäß ist auch eine Steuereinrichtung vorgesehen, welche dazu ausgelegt ist, das erfindungsgemäße Verfahren oder mögliche Ausgestaltungen des erfindungsgemäßen Verfahrens durchzuführen. Die Steuereinrichtung kann eine physisch integrierte Einheit oder eine logisch zusammenwirkende Einheit aus mehreren Steuergeräten umfassen, die über eine Kommunikationsschnittstelle verbunden sind und gemeinsam die Funktionalität des erfindungsgemäßen Verfahrens bereitstellen, unabhängig davon, ob die Funktionalität vollständig oder teilweise durch eines oder mehrere Steuergeräte bereitgestellt wird, wobei die Steuergeräte zusammenwirken können, um die Logik des Verfahrens zu implementieren. Beispiele für solche Steuergeräte sind: Motorsteuergerät, Lenksystemsteuergerät, zentrales Fahrzeugsteuergerät, Bordnetzsteuergerät oder ein dediziertes Überwachungssteuergerät für elektrische Steckverbindungen. Zudem kann die Steuereinrichtung auf einen oder mehrere Sensoren zugreifen, um das Verfahren durchzuführen. Zum Beispiel kann die Steuereinrichtung auf einen Lenkwinkelsensor, Stromsensor, Spannungssensor, Temperatursensor an einer Steckverbindungen, Lichtbogensensor, elektrische und/oder magnetische Feldsensoren und/oder Leistungsmesssensoren zugreifen. Alternativ oder zusätzlich kann die Steuereinrichtung auch andere Mittel zur Überwachung des Lenksystems aufweisen, wie beispielsweise Signalanalyseschaltungen, Frequenzanalysatoren, Mustererkennungsalgorithmen oder künstliche Intelligenz zur Identifikation charakteristischer Fehlerbilder. Die Steuereinrichtung kann weiterhin Aktoren oder Schaltmittel ansteuern, die dazu ausgelegt sind, bei Erkennung eines Lichtbogens entsprechende Maßnahmen zur Spannungsreduzierung oder -abschaltung einzuleiten, wie beispielsweise Phasentrenner, Halbleiterschalter, Relais, Sicherungen oder Nullspannungsschaltelemente für Wechselrichter.

Erfindungsgemäß ist auch eine Steckverbindung für ein Lenksystem vorgesehen, welche dazu ausgelegt ist, mit dem erfindungsgemäßen Verfahren überwacht zu werden, wobei die Steckverbindung eine strukturelle Ausgestaltung aufweist, die bei einem Fehler ein charakteristisches Signal erzeugt, und wobei die Steckverbindung einen Schaltkontakt umfassen kann, der beim Trennen der Steckverbindung aktiviert wird und die Steckverbindung in einen spannungsfreien Zustand versetzt.

Erfindungsgemäß ist auch ein Kraftfahrzeug vorgesehen, welches die erfindungsgemäße Steuereinrichtung oder mögliche Ausgestaltungen des erfindungsgemäßen Steuereinrichtung aufweist.

Weitere Merkmale der Erfindung können sich aus der nachfolgenden Figurenbeschreibung sowie anhand der Zeichnung ergeben. Die vorstehend in der Beschreibung genannten Merkmale und Merkmalskombinationen sowie die nachfolgend in der Figurenbeschreibung und/oder in den Figuren allein gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Die Zeichnung zeigt in:
- Fig. 1: eine schematische Darstellung eines Kraftfahrzeugs mit einem Lenksystem und einer Steuereinrichtung zur Durchführung des erfindungsgemäßen Verfahrens;
- Fig. 2: eine schematische Darstellung einer Steckverbindung mit einem Stecker und einer Buchse, wobei der Stecker eine strukturelle Ausgestaltung in Form einer Konturierung der elektrischen Kontaktelemente aufweist;
- Fig. 3: eine schematische Darstellung einer B6-Brückenschaltung eines Wechselrichters und einem daran angeschlossenen Lenkungsmotor.

Gleiche oder funktionsgleiche Elemente sind in den Figuren mit den gleichen Bezugszeichen versehen.

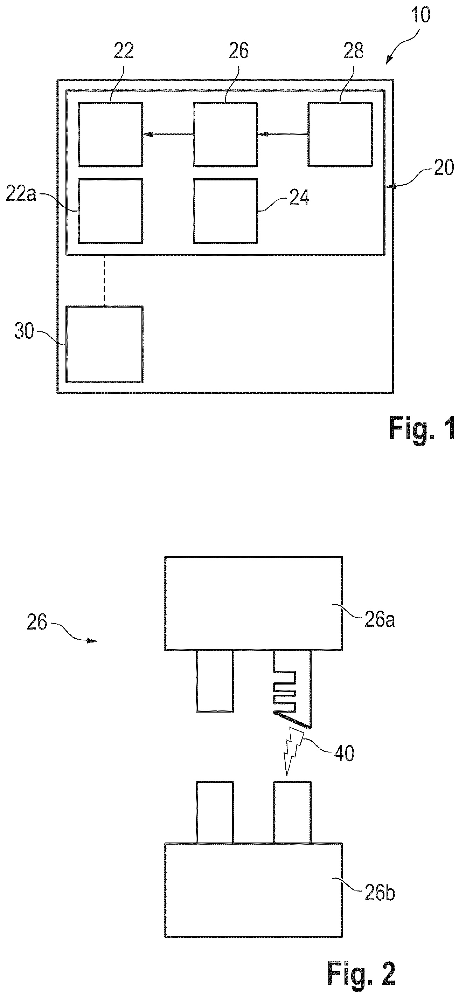

Ein Kraftfahrzeug 10 ist in einer schematischen Darstellung in Fig. 1 gezeigt. Das Kraftfahrzeug 10 umfasst ein Lenksystem 20 und eine Steuereinrichtung 30, welche dazu ausgelegt ist, das erfindungsgemäße Verfahren durchzuführen. Das Lenksystem 20 weist einen Lenkungsmotor 22, ein Lenkungsmotorsteuergerät 22a, eine Sensorik 24, eine elektrische Steckverbindung 26 sowie einen Wechselrichter 28 auf. Die Pfeile zwischen dem Wechselrichter 28, der Steckverbindung 26 und dem Lenkungsmotor 22 sollen hierbei andeuten, dass die Energieversorgung des Lenkungsmotors 22 über einen Wechselrichter 28 erfolgt, wobei die Steckverbindung 26 eine elektrische Verbindung zwischen dem Wechselrichter 28 und dem Lenkungsmotor 22 herstellt. Ferner deutet die gestrichelte Linie zwischen dem Lenksystem 20 und der Steuereinrichtung 30 an, dass die Steuereinrichtung 30 auf das Lenksystem 20 zugreifen bzw. mit diesem interagieren kann, d. h. beispielsweise Daten von der Sensorik 24 empfangen oder den Wechselrichter 28 ansteuern kann.

Es erfolgt das Erfassen eines zeitlichen Signalverlaufs eines Ist-Wertes einer Spannung und einer Stromstärke an der elektrischen Steckverbindung 24 des Lenksystems 20. Der zeitliche Signalverlauf kann beispielsweise mittels eines im Lenkungsmotorsteuergerät 22a integrierten Analog-Digital-Wandlers erfasst werden, welcher mit entsprechenden Messwiderständen (Shunts) für die Strommessung und Spannungsteilern für die Spannungsmessung verbunden ist. Alternativ oder zusätzlich können dedizierte Stromsensoren, wie Hall-Effekt-Sensoren oder magnetoresistive Sensoren, sowie Spannungsmessschaltungen an der elektrischen Steckverbindung 26 angeordnet sein, welche ihre Messwerte über eine geeignete Signalleitung an die Steuereinrichtung 30 übermitteln.

Die elektrische Steckverbindung 26 ist in einer schematischen Darstellung in Fig. 2 gezeigt. Die elektrische Steckverbindung 26 weist einen Stecker 26a und eine Buchse 26b auf, wobei der Stecker 26a eine strukturelle Ausgestaltung in Form einer Konturierung der elektrischen Kontaktelemente aufweist. Angedeutet ist ferner ein Lichtbogen 40.

Es erfolgt das Erkennen des Lichtbogens 40 anhand eines für den Lichtbogen 40 charakteristischen Signals, welches zumindest ein durch die strukturelle Ausgestaltung der elektrischen Steckverbindung 26 bedingtes charakteristisches Muster aufweist, wobei die strukturelle Ausgestaltung vorliegend durch die Konturierung der elektrischen Kontaktelemente des Steckers 26a verwirklicht ist. Das von dem Lichtbogen 40 erzeugte charakteristische Signal kann sich sowohl in der Spannung als auch in der Stromstärke manifestieren. Bei der Spannung ist typischerweise ein plötzlicher kurzzeitiger Einbruch mit anschließendem Wiederanstieg zu beobachten, wobei überlagerte hochfrequente Oszillationen auftreten können. Diese Spannungsschwankungen können eine charakteristische Signatur aufweisen, die von der spezifischen Konturierung der elektrischen Kontaktelemente des Steckers 26a beeinflusst wird. Im Stromverlauf zeigt sich oft ein abrupter Anstieg, gefolgt von raschen Fluktuationen mit charakteristischen Frequenzkomponenten.

Zusätzlich wird an zumindest zwei Messpunkten im Bordnetz aus dem zeitlichen Verlauf des Ist-Wertes jeweils eine elektrische Leistungsbilanz berechnet, wobei eine zeitliche Änderung der Leistungsbilanz an verschiedenen Messpunkten im Bordnetz erfasst wird und anhand eines Vergleichs der jeweiligen Leistungsbilanzen an den zumindest zwei Messpunkten eine Lokalisierung des Lichtbogens 40 im Bordnetz des Kraftfahrzeugs 10 erfolgt. Zur Berechnung und Analyse derartiger Leistungsbilanzen können im Bordnetz des Kraftfahrzeugs 10 strategisch platzierte Messpunkte verwendet werden. Ein erster Messpunkt kann beispielsweise unmittelbar am Ausgang des Lenkungsmotorsteuergeräts 22a angeordnet sein, während ein zweiter Messpunkt direkt am Eingang des Lenkungsmotors 22 positioniert ist. Durch Multiplikation der gemessenen Stromstärke und Spannung an jedem dieser Punkte wird die jeweilige elektrische Leistung (P = U × I) in Echtzeit berechnet. Bei normalem Betrieb sollte die Differenz der Leistungsbilanzen zwischen diesen Messpunkten nur die üblichen Leitungsverluste widerspiegeln und relativ konstant sein. Tritt jedoch ein Lichtbogen 40 auf, wird an der betroffenen Stelle Energie in Form von Wärme, Licht und elektromagnetischer Strahlung freigesetzt. Dies führt zu einer abrupten Änderung in der Leistungsbilanz, wobei die Differenz zwischen den Messpunkten signifikant ansteigt. Durch kontinuierliche Überwachung und Vergleich der zeitlichen Leistungsverläufe an den verschiedenen Messpunkten kann die Steuereinrichtung 30 feststellen, zwischen welchen Messpunkten der Lichtbogen 40 aufgetreten ist. Je mehr Messpunkte im System implementiert sind, desto präziser kann die Position des Lichtbogens eingegrenzt werden. Bei komplexeren Systemen können zusätzliche Messpunkte an weiteren Steckverbindungen oder Verzweigungspunkten des Bordnetzes platziert werden, um eine noch genauere Lokalisierung zu ermöglichen.

Das Erkennen des Lichtbogens 40 erfolgt ferner anhand einer Messung von Licht, welches vom Lichtbogen 40 emittiert wird. Das Erkennen des Lichtbogens 40 mittels Lichtmessung kann z. B. durch optische Sensoren (hier nicht dargestellt) erfolgen, die in unmittelbarer Nähe zu der elektrischen Steckverbindung 26 angeordnet sind.

Das Erkennen des Lichtbogens 40 erfolgt ferner anhand einer Messung elektrischer und/oder magnetischer Felder, welche von dem Lichtbogen 40 erzeugt werden. Das Erkennen des Lichtbogens 40 anhand elektrischer und/oder magnetischer Felder kann z. B. durch einen spezialisierten Felddetektor (hier nicht dargestellt) wie beispielsweise einen Hall-Sensor erfolgen, der in unmittelbarer Nähe zu der elektrischen Steckverbindung 26 angeordnet ist. Alternativ oder zusätzlich dazu können kleine Induktionsspulen (hier nicht dargestellt) installiert sein, die die schnellen Feldänderungen in elektrische Signale umwandeln. Die Signale der genannten Sensoren werden von der Steuereinrichtung 30 erfasst, welche anhand charakteristischer Signale den Lichtbogen 40 identifiziert.

Das Erkennen des Lichtbogens 40 erfolgt ferner anhand eines für den Lichtbogen 40 charakteristischen Signals, welches mittels einer Sensorik 24 des Lenksystems 20 erfasst wird. Hierzu kann die Sensorik 24 beispielsweise einen Lenkwinkelsensor (hier nicht dargestellt) und einen Motor-Positions-Sensor (hier nicht dargestellt) aufweisen, welche im normalen Betrieb kontinuierlich die Position des Lenkrades (hier nicht dargestellt) bzw. des Lenkungsmotors 22 überwachen. Die genannten Sensoren zeigen bei Auftreten eines Lichtbogens 40 charakteristische Signale in ihren Signalverläufen. Die Steuereinrichtung 30 analysiert diese Signale in Echtzeit und kann so einen Lichtbogen 40 detektieren.

Es erfolgt das Durchführen zumindest einer Maßnahme, wenn der Lichtbogen 40 erkannt wurde, wobei die Maßnahme ein Absenken oder Abschalten einer Spannung im Bordnetz umfasst. Bei Erkennung des Lichtbogens 40 leitet die Steuereinrichtung 30 umgehend Schutzmaßnahmen ein, um Schäden am Lenksystem 20 zu vermeiden, also beispielsweise eine gezielte Spannungsreduktion des Bordnetzes.

Alternativ oder zusätzlich kann die Steckverbindung 26 einen mechanischen Schaltkontakt (hier nicht dargestellt) zur Unterbrechung der Spannung umfassen, und wobei die Maßnahme das Versetzen der Steckverbindung in einen spannungsfreien Zustand umfasst, indem der mechanische Schaltkontakt beim physischen Trennen der Steckverbindung aktiviert wird.

Ferner erfolgt das Versetzen des Lenkungsmotorsteuergeräts 22a in einen spannungsfreien Zustand, indem ein im elektrischen Versorgungspfad des Lenkungsmotorsteuergeräts 22a angeordneter Phasentrenner (hier nicht dargestellt) ausgelöst wird. Der im elektrischen Versorgungspfad des Lenkungsmotorsteuergeräts 22a angeordnete Phasentrenner stellt einen speziellen Sicherheitsmechanismus dar, der bei Erkennung des Lichtbogens 40 aktiviert wird undbei Auslösung durch die Steuereinrichtung 30 innerhalb sehr kurzer Zeit den Stromfluss vollständig unterbrechen kann, wodurch das Lenkungsmotorsteuergerät 22a galvanisch vom Bordnetz getrennt und somit spannungsfrei geschaltet wird. Hierdurch können Schäden am Lenkungsmotorsteuergerät 22a vermieden werden.

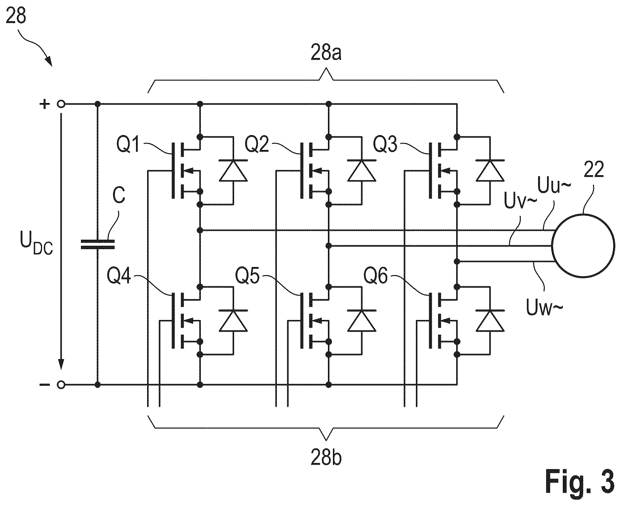

Eine schematische Darstellung des Wechselrichters 28 und des daran angeschlossenen Lenkungsmotors 22 ist in Fig. 3 gezeigt, wobei die Steckverbindung aus Gründen der Übersichtlichkeit in Fig. 3 nicht dargestellt ist. Der Wechselrichter 28 ist als B6-Brücke ausgeführt und umfasst drei High-Side-Schalter 28a und drei Low-Side-Schalter 28b. Dargestellt sind ferner die Gleichspannung U des Bordnetzes, welche als Eingangsspannung für den Wechselrichter 28 dient, ein Zwischenkreiskondensator zur Glättung dieser Gleichspannung, sowie die drei Phasenausgänge Uu, Uv und Uw, die über entsprechende Leitungen mit den Wicklungen des Lenkungsmotors 22 verbunden sind. Die Schalter Q1 bis Q6 sind als leistungselektronische Halbleiterbauelemente, beispielsweise MOSFETs oder IGBTs, ausgeführt.

Es erfolgt das Versetzen des Lenkungsmotors 22 in einen spannungsfreien Zustand, indem die Schaltelemente des mit dem Lenkungsmotor 22 verbundenen Wechselrichters 28 so angesteuert werden, dass an der elektrischen Steckverbindung 26, an welcher der Lichtbogen 40 erkannt wurde, keine Spannung mehr anliegt. Hierzu werden die Schaltelemente des Wechselrichters 28 in einen Nullspannungszustand geschaltet. Dies erfolgt, indem entweder alle High-Side-Schalter (Q1, Q2, Q3) gleichzeitig eingeschaltet und alle Low-Side-Schalter (Q4, Q5, Q6) ausgeschaltet werden, oder umgekehrt alle High-Side-Schalter ausgeschaltet und alle Low-Side-Schalter eingeschaltet werden. Durch diese symmetrische Ansteuerung wird gewährleistet, dass an allen Phasenanschlüssen des Lenkungsmotors 22 (Uu, Uv, Uw) das gleiche elektrische Potential anliegt, wodurch zwischen beliebigen Punkten der Motorwicklungen und damit auch an der elektrischen Steckverbindung 26 keine Spannungsdifferenz mehr existiert. Dadurch wird der Lichtbogen 40 unmittelbar gelöscht, da ihm die für seine Aufrechterhaltung notwendige elektrische Energie entzogen wird.

### Bezugszeichenliste

- 10: Kraftfahrzeug
- 20: Lenksystem
- 22: Lenkungsmotor
- 22a: Lenkungsmotorsteuergerät
- 24: Sensorik
- 26: Elektrische Steckverbindung
- 26a: Stecker
- 26b: Buchse
- 28: Wechselrichter
- 28a: Schaltelemente (High-Side-Schalter)
- 28b: Schaltelemente (Low-Side-Schalter)
- 30: Steuereinrichtung
- 40: Lichtbogen

## Patentansprüche

1. Verfahren zur Lichtbogenerkennung an einer elektrischen Steckverbindung (26) eines Lenksystems (20) eines Kraftfahrzeugs (10), umfassend die Schritte:
- Erfassen eines zeitlichen Signalverlaufs eines Ist-Wertes einer Spannung und/oder Stromstärke zumindest an einer elektrischen Steckverbindung (26) des Lenksystems (20);
- Erkennen eines Lichtbogens (40) anhand eines für den Lichtbogen (40) charakteristischen Signals, welches zumindest ein durch die strukturelle Ausgestaltung der elektrischen Steckverbindung (26) bedingtes charakteristisches Muster aufweist, wobei die strukturelle Ausgestaltung eine spezifische Form, Anordnung oder definierte Anzahl von Kontaktelementen umfasst;
- Durchführen zumindest einer Maßnahme, wenn ein Lichtbogen (40) erkannt wurde, wobei die Maßnahme ein Absenken oder Abschalten einer Spannung im Bordnetz umfasst.

2. Verfahren nach Anspruch 1, wobei zusätzlich an zumindest zwei Messpunkten im Bordnetz aus dem zeitlichen Verlauf des Ist-Wertes jeweils eine elektrische Leistungsbilanz berechnet wird, wobei eine zeitliche Änderung der Leistungsbilanz an verschiedenen Messpunkten im Bordnetz erfasst wird und anhand eines Vergleichs der jeweiligen Leistungsbilanzen an den zumindest zwei Messpunkten eine Lokalisierung des Lichtbogens (40) im Bordnetz erfolgt.

3. Verfahren nach einem der vorhergehenden Ansprüche, wobei das Erkennen des Lichtbogens (40) ferner anhand einer Messung von Licht erfolgt, welches vom Lichtbogen (40) emittiert wird.

4. Verfahren nach einem der vorhergehenden Ansprüche, wobei das Erkennen des Lichtbogens (40) ferner anhand einer Messung elektrischer und/oder magnetischer Felder erfolgt, welche von dem Lichtbogen (40) erzeugt werden.

5. Verfahren nach einem der vorhergehenden Ansprüche, wobei das Erkennen des Lichtbogens (40) ferner anhand eines für den Lichtbogen (40) charakteristischen Signals erfolgt, welches mittels einer Sensorik (24) des Lenksystems (20) erfasst wird.

6. Verfahren nach einem der vorhergehenden Ansprüche, wobei die elektrische Steckverbindung (26) einen mechanischen Schaltkontakt zur Unterbrechung der Spannung umfasst, und wobei die Maßnahme das Versetzen der elektrischen Steckverbindung (26) in einen spannungsfreien Zustand umfasst, indem der mechanische Schaltkontakt beim physischen Trennen der elektrischen Steckverbindung (26) aktiviert wird.

7. Verfahren nach einem der vorhergehenden Ansprüche, wobei die Maßnahme das Versetzen des Lenkungsmotorsteuergeräts (22a) in einen spannungsfreien Zustand umfasst, indem ein im elektrischen Versorgungspfad des Lenkungsmotorsteuergeräts (22a) angeordneter Phasentrenner ausgelöst wird.

8. Verfahren nach einem der vorhergehenden Ansprüche, wobei die Maßnahmen das Versetzen des Lenkungsmotors (22) in einen spannungsfreien Zustand umfasst, indem die Schaltelemente (28a, 28b) eines mit dem Lenkungsmotor (22) verbundenen Wechselrichters (28) so angesteuert werden, dass an der elektrischen Steckverbindung (26), an welcher der Lichtbogen (40) erkannt wurde, keine Spannung mehr anliegt.

9. Steuereinrichtung (30), welche dazu ausgelegt ist, ein Verfahren nach einem der vorhergehenden Ansprüche durchzuführen.

10. Kraftfahrzeug (10) mit einer Steuereinrichtung (30) nach Anspruch 9.
